(19) Europäisches Patentamt
European Patent Office
Office européen des brevets

(11) **EP 3 689 593 B1**

(12) **EUROPEAN PATENT SPECIFICATION**

(45) Date of publication and mention
of the grant of the patent:
**08.06.2022 Bulletin 2022/23**

(51) International Patent Classification (IPC):
**B32B 3/30** (2006.01)   **B32B 27/28** (2006.01)
**B32B 7/12** (2006.01)   **H01L 25/075** (2006.01)

(21) Application number: **18863099.0**

(22) Date of filing: **17.09.2018**

(52) Cooperative Patent Classification (CPC):
**B32B 3/30; B32B 7/12; B32B 27/08; B32B 27/281;**
**B32B 27/283; B32B 27/308; B32B 27/32;**
**B32B 27/36; B32B 27/365; B32B 27/40;**
**H01L 33/0095;** B32B 2250/02; B32B 2250/24;
B32B 2307/412; B32B 2307/51;   (Cont.)

(86) International application number:
**PCT/KR2018/010899**

(87) International publication number:
**WO 2019/066344 (04.04.2019 Gazette 2019/14)**

(54) **PATTERNED FILM FOR TRANSFERRING DISPLAY PIXELS AND METHOD FOR PREPARING DISPLAY USING SAME**

GEMUSTERTER FILM ZUR ÜBERTRAGUNG VON ANZEIGEPIXELN UND VERFAHREN ZUR HERSTELLUNG EINER ANZEIGE MIT VERWENDUNG DAVON

FILM MODELÉ POUR TRANSFÉRER DES PIXELS D'AFFICHAGE ET PROCÉDÉ DE PRÉPARATION D'AFFICHAGE UTILISANT CELUI-CI

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **26.09.2017 KR 20170124183**

(43) Date of publication of application:
**05.08.2020 Bulletin 2020/32**

(73) Proprietor: **LG Chem, Ltd.**
**Seoul 07336 (KR)**

(72) Inventors:
• **KOO, Beom Mo**
**Daejeon 34122 (KR)**
• **KIM, Jooyeon**
**Daejeon 34122 (KR)**
• **HAN, Wonsang**
**Daejeon 34122 (KR)**
• **LEE, Seung Heon**
**Daejeon 34122 (KR)**

(74) Representative: **Goddar, Heinz J.**
**Boehmert & Boehmert**
**Anwaltspartnerschaft mbB**
**Pettenkoferstrasse 22**
**80336 München (DE)**

(56) References cited:
**CN-A- 107 154 374       JP-A- 2011 016 330**
**JP-A- 2016 188 344       JP-A- 2017 002 235**
**KR-A- 20100 125 010     KR-B1- 100 960 900**
**KR-B1- 101 754 528**

(52) Cooperative Patent Classification (CPC): (Cont.)
    B32B 2307/748; B32B 2457/20; H01L 25/0753

**Description**

[Technical Field]

The present invention relates to a pattern film for transferring a display pixel and a method for manufacturing a display using the same.

[Background Art]

In recent years, a demand of a lighting apparatus and the like configured by a light emitting diode (LED) has explosively increased due to an advantage in that the lighting device has a long life-span and consumes relatively low power as compared with an existing incandescent lamp or fluorescent lamp and does not discharge pollutants in a manufacturing process and an application area of the LED has been gradually diversified such as application of a display device using light emission and a backlight element of a lighting device or an LCD display device.

In particular, the LED has an advantage in that the LED can be driven with comparatively low voltage and has low heat emission and the long life-span due to high energy efficiency and as a technology is developed, which can provide white light which is difficult to implement in the related art with high luminance, it is expected that the LED can replace most light source devices which are currently used.

KR 101 754 528 B1 discloses a pattern film for transferring a display pixel, comprising a polydimethylsiloxane-based film comprising a projection pattern on the surface, wherein a form of a projection constituting the projection pattern is a polygonal pillar or cylindrical pillar form and an upper surface of the projection is a flat form.

[Disclosure]

[Technical Problem]

The present invention has been made in an effort to provide a pattern film for transferring a display pixel and a method for manufacturing a display using the same.

[Technical Solution]

The present invention provides a pattern film for transferring a display pixel, which comprises: a substrate; and a polydimethylsiloxane-based film provided on the substrate and comprising a projection pattern on the surface, in which a form of a projection constituting the projection pattern is a polygonal pillar or cylindrical pillar form and an upper surface of the projection is a flat form which means a 10-point surface roughness $R_z$ of 0.5 $\mu$m or less, a height of the projection pattern is in the range of 20 to 50 $\mu$m, an area ratio occupied by the projection pattern is in the range of 1% to 5% based on an upper plane of the polydimethylsiloxane-based film, and the projection pattern comprises a primary projection pattern and an auxiliary projection pattern, and upper areas of respective auxiliary projections constituting the auxiliary projection pattern are 5 to 20% of the upper areas of respective primary projections constituting the primary projection pattern.

Further, another embodiment of the present invention provides a manufacturing method of a display, which comprises: preparing said pattern film for transferring a display pixel; providing a display pixel on the surface of a primary projection pattern; and transferring the display pixel to an electrode substrate for a display.

Further embodiments are disclosed in the dependent claims.

[Advantageous Effects]

According to an embodiment of the present invention, since a projection pattern is formed on the surface of the polydimethylsiloxane-based film, a contact surface between the electrode surface and the polydimethylsiloxane-based film can be reduced during the transfer of the display pixel and the polydimethylsiloxane-based film has excellent mold release properties after transfer of the display pixel.

Further, according to an embodiment of the present invention, when a pattern film for transferring the display pixel is used, since only light emitting diode chips at a specific interval among light emitting diode chips formed on a wafer are selectively contacted, it is possible to prevent contamination of the wafer.

In addition, according to the present invention, the projection pattern additionally comprises an auxiliary projection pattern in addition to a main projection pattern to prevent the primary projection pattern for transfer pressure from being deformed, and as a result, it is possible to reduce unnecessary contact with an electrode substrate.

[Description of Drawings]

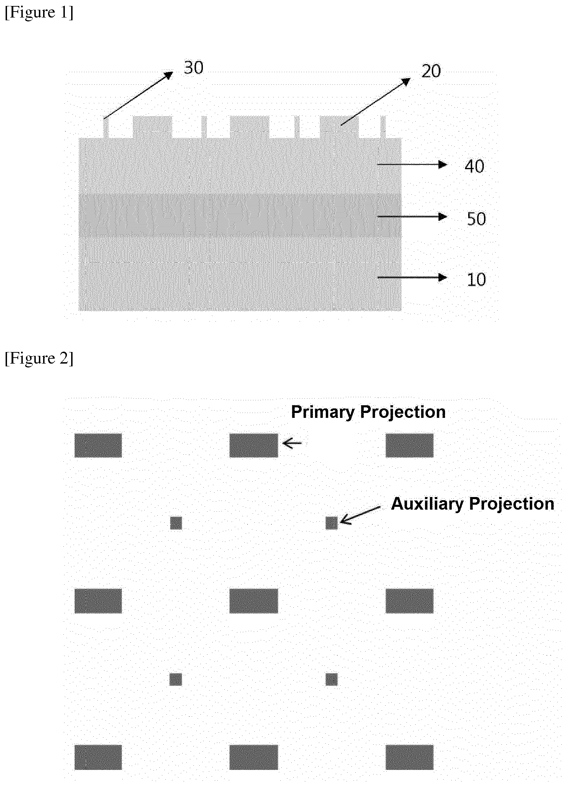

FIGS. 1 and 2 are diagrams schematically illustrating a pattern film for transferring a display pixel according to an embodiment of the present invention, respectively.

<Explanation of Reference Numerals and Symbols>

    10: Substrate
    20: Primary projection pattern
    30: Auxiliary projection pattern
    40: Polydimethylsiloxane-based film
    50: Adhesive layer

[Best Mode]

Hereinafter, the present invention will be described in detail.

A transfer is a series of actions to transport a single micro LED or multiple micro LEDs to a counter substrate. A method for transporting an LED single chip in the related art is applied in a package process by using a Pick & Place equipment, but a technology is required, which transports the LED single chip with high precision as an LED size decreases up to several micrometers. To this end, technology development has been carried out in two methods of direct transfer and print transfer up to now. The direct transfer may be defined as a technology that directly bonds a material or a thin film to be transported to a target substrate and the print transfer may be defined as a technology that uses an intermediate medium such as an electrostatic or bonding stamp. Representative technologies of the direct transfer and print transfer schemes are as follows.

A direct transfer scheme is a scheme that separates p-type GaN into a size of several micrometers by an etching process and thereafter, directly bonds the p-type GaN to a substrate with a minute switching element such as CMOS. A silicon or sapphire substrate used as a growth substrate may be removed as necessary and GaN individual elements having the size of several-micrometers, which are separated into a single size are combined with a switching minute electronic element to be manufactured so as to easily adjust operating current. Such a method is advantageous in that LED manufacturing and transfer methods are easy, but quality management of each element becomes a very important element.

It is known that there are two methods up to now as a print-type transfer method. As a first method, a method is proposed, which uses an electrostatic head of Luxvue of U.S.A. The method is a principle in which voltage is applied to a head portion made of a silicon material to generate adhesion with a micro LED by a charging phenomenon. Such a method has an advantage in that a desired area or single element may be selectively transported, but may have a problem in that the micro LED is damaged by the charging phenomenon by voltage applied to a head during electrostatic induction. A second method as a method developed by X-Celeprint of U.S.A. is a method that transports an LED on a wafer to a desired substrate by applying a transfer head to an elastic polymer material. There is no problem for LED damage, but only when the adhesion of an elastic transfer head is larger than the adhesion of a target substrate during a transfer process, the micro LED may be stably transported and an additional process for forming an electrode is required as compared with an electrostatic head scheme. Further, persistently maintaining the adhesion of an elastic polymer material also acts as a very important element.

Therefore, the present invention intends to provide a transfer pattern film for forming a display pixel, which is excellent in transfer characteristic.

A pattern film for transferring a display pixel according to an embodiment of the present invention comprises a substrate; and a polydimethylsiloxane-based film provided on the substrate and comprising a projection pattern on the surface, and a form of a projection configuring the projection pattern is a polygonal pillar form or a cylindrical form, an upper surface of the projection is a flat form, a height of the projection pattern is in the range of 20 μm to 50 μm, an area ratio occupied by the projection pattern is in the range of 1% to 5% based on an upper plane of the polydimethylsiloxane-based film, and the projection pattern comprises a primary projection pattern and an auxiliary projection pattern, and upper areas of respective auxiliary projections constituting the auxiliary projection pattern are 5% to 20% of the upper areas of respective primary projections constituting the primary projection pattern.

In the present invention, the display pixel may be a light emitting diode (LED) chip. Each of horizontal and vertical sizes of the LED chip may be in the range of 10 μm to 100 μm or in the range of 25 μm to 50 μm.

In the present invention, the substrate may be a glass substrate or a transparent plastic substrate having excellent transparency, surface smoothness, ease of handling, and waterproofness, but is not limited thereto and is not limited as long as it is a transparent substrate ordinarily used in an electronic device. Specifically, the transparent substrate may be made of glass; polycarbonate resin; urethane resin; polyimide resin; polyester resin; (meth)acrylate-based polymer resin; and polyolefin-based resin such as polyethylene or polypropylene.

A thickness of the substrate may be in the range of 100 $\mu$m to 1000 $\mu$m or in the range of 300 $\mu$m to 700 $\mu$m, but is not limited only thereto.

In the present invention, the area ratio occupied by the projection pattern may be in the range of 1% to 5%, and in the range of 1% to 3.5% based on the upper plane of the polydimethylsiloxane-based film. When the area ratio occupied by the projection pattern is more than 5% based on the upper plane of the polydimethylsiloxane-based film, detachment from the electrode substrate may be difficult during the transfer process and when the area ratio is less than 1%, an available space in which the LED chip may be seated at a correct position of a top of the projection is insufficient, and as a result, defective alignment may occur.

The area ratio occupied by the projection pattern may be calculated by Equation 1 below.

[Equation 1]

$$\text{Area ratio (\%) occupied by projection pattern} = \{[(a \times b) + (c \times d)] / \text{Pitch}^2\} \times 100$$

In Equation 1 above, (a $\times$ b) represents the upper area of the primary projection, (c $\times$ d) represents the upper area of the auxiliary projection, and Pitch represents a pitch of the primary projection pattern.

In the present invention, the form of the projection constituting the projection pattern is the polygonal pillar or cylindrical pillar form and the upper surface of the projection is the flat form. More specifically, the form of the projection constituting the projection pattern may be a pillar form such as a quadrangular pillar, a cylindrical pillar, or the like and when the surface of the projection has the flat form, a risk such as the damage of the LED chip or the like may be reduced. In the present invention, the "flat form" means a 10-point surface roughness Rz of 0.5 $\mu$m or less. The Rz may be measured by Mitutoyo SJ301 measurement equipment.

The upper area of the primary projection may vary depending on a resolution and a design structure of the display, and more particularly, may be 10 times to 20 times of the size of the display pixel, but is not limited only thereto. Further, the forms of the primary projection and the auxiliary projection may be the quadrangular pillar and in this case, the upper area of the primary projection may be 100 $\mu$m $\times$ 200 $\mu$m, 100 $\mu$m $\times$ 150 $\mu$m, or the like and the upper area of the auxiliary projection may be 50 $\mu$m $\times$ 50 $\mu$m or the like.

In the present invention, a height of the projection pattern may be in the range of 20 $\mu$m to 50 $\mu$m. When the height of the projection pattern is less than 20 $\mu$m, since a height step is not sufficient, the polydimethylsiloxane-based film is deformed even by very low transfer pressure to make a full contact and when the height of the projection pattern is more than 50 $\mu$m, pattern duplication and master mold supply become difficult.

Further, the interval between the projection patterns, that is, the pitch of the projection pattern may be determined by the display resolution and a repetition form of a sub-pixel considering a yield or the like may also be comprised. More specifically, each of the pitch of the primary projection pattern and the pitch of the auxiliary projection pattern may be independently in the range of 700 $\mu$m to 900 $\mu$m or may be approximately 800 $\mu$m, but is not limited only thereto.

The pitch of the projection pattern may be arbitrarily changed according to the display resolution, but when the projection pitch is equal to or less than a predetermined value, the contact area at the time of transfer may be relatively large, which is advantageous for detachment. Therefore, in the present invention, the pitch of the projection pattern for selective transfer of the LED chip is preferably in the range of 700 $\mu$m to 900 $\mu$m. When the pitch of the projection pattern is less than 700 $\mu$m, there is a disadvantage in that it is difficult to apply the projection pattern, such as designing a too small size of a pixel to be transferred, etc.

In the present invention, the projection pattern is used for selectively transferring only a chip separated by a specific pixel pitch among the LED chips on the wafer and only specific pixel chips are selectively contacted and transferred to prevent unnecessary contact, contamination, or the like and easily detach the LED chip.

In the present invention, the projection pattern comprises the primary projection pattern and the auxiliary projection pattern and the upper areas of the respective auxiliary projections constituting the auxiliary projection pattern are 5 % to 20% of the upper areas of the respective primary projections constituting the primary projection pattern. The upper areas of the respective auxiliary projections constituting the auxiliary projection pattern may be 5% to 15% of the upper areas of the respective primary projections constituting the primary projection pattern.

When the projection pattern is constituted only by the primary projection pattern, deformation may occur due to the transfer pressure during the transfer process and when the deformation is excessive, the unnecessary contact with the electrode substrate occurs, thereby significantly deteriorating releasability of a pattern film for transfer after the transfer process. Therefore, in the present invention, the auxiliary projection pattern is additionally comprised in addition to the primary projection pattern to prevent the deformation of the primary projection pattern for the transfer pressure, thereby reducing the unnecessary contact with the electrode substrate.

The auxiliary projection pattern is used for preventing the deformation of the primary projection pattern for the transfer pressure and a position on the polydimethylsiloxane-based film where the auxiliary projection pattern is provided is not particularly limited. For example, the auxiliary projection may be provided between two adjacent primary projections and may be provided at the center of gravity of a virtual polygon having four adjacent primary projections as vertexes, but the present invention is not limited only thereto.

In the present invention, the polydimethylsiloxane-based film comprising the projection pattern on the surface may be manufactured from a master mold comprising a groove portion pattern corresponding to the projection pattern. The master mold comprising the groove portion pattern may be manufactured by using a method known in the art and more specifically, may be manufactured by using a photolithography method, but the present invention is not limited only thereto.

Since the polydimethylsiloxane-based film is excellent in mold duplication and releasability, the polydimethylsiloxane-based film may be more effectively applied to the pattern film for transferring the display pixel according to the present invention. It is difficult that a UV curable polyurethane resin (poly urethane acrylate (PUA)) primarily used for duplication in the related art has appropriate hardness and adhesion which affect a transfer characteristic.

In the related art, it is very difficult to release the polydimethylsiloxane-based film after transferring the display pixel to a desired electrode substrate due to a self-adhesive property of the surface of the polydimethylsiloxane-based film. However, in the present invention, since a projection pattern having a specific area ratio and a specific height is formed on the surface of the polydimethylsiloxane-based film, a contact surface between the electrode surface and the polydimethylsiloxane-based film may be reduced during the transfer of the display pixel and the polydimethylsiloxane-based film has excellent mold release properties after transferring the display pixel.

A thickness of the polydimethylsiloxane-based film may be in the range of 200 $\mu$m to 800 $\mu$m or in the range of 300 $\mu$m to 600 $\mu$m by considering size deformation or the like, but is not limited only thereto.

In the present invention, the adhesion of the surface of the projection pattern may be equal to or less than 58.84 kPa (600 gf/cm$^2$). The adhesion of the surface of the projection pattern is a maximum load value applied when a glass substrate having an area of 1 cm $\times$ 1 cm is in contact with the surface of the projection pattern with a load of 9.81 N (1,000 gf) for 30 seconds and then released. Further, the adhesion of the surface of the projection pattern may be equal to or more than 29.42 kPa (300 gf/cm$^2$). When the adhesion of the surface of the projection pattern is less than 29.42 kPa (300 gf/cm$^2$), the LED chip may be separated or lost due to insufficient adhesion during inter-process handling or unnecessary rotation may occur.

In the present invention, an adhesive layer may be additionally comprised between the substrate and the polydimethylsiloxane-based film.

A material known in the art may be used for the adhesive layer and more specifically, a pressure sensitive adhesive (PSA) may be used, and an acrylic adhesive, a synthetic rubber adhesive, or the like may be used, but the adhesive layer is not limited only thereto. Further, in an embodiment of the present invention, as the adhesive layer, a double-sided PSA may be used and in this case, one surface of the double-sided PSA may comprise a silicon-based adhesive and the other surface may comprise an acrylic adhesive. Therefore, bonding of heterogeneous materials may be excellent.

The thickness of the substrate may be in the range of 30 $\mu$m to 300 $\mu$m or in the range of 50 $\mu$m to 150 $\mu$m, but is not limited only thereto.

A pattern film for transferring a display pixel according to an embodiment of the present invention is schematically illustrated in FIGS. 1 and 2 below.

Further, a manufacturing method of a display according to an embodiment of the present invention comprises: preparing a pattern film for transferring the display pixel; providing the display pixel on the surface of the primary projection pattern; and transferring the display pixel to an electrode substrate for the display.

The providing of the display pixel on the surface of the projection pattern may be performed by a lift-off technology using a laser, but is not limited only thereto.

In the transferring the display pixel to the electrode substrate for the display, a method for attaching the display pixel to an electrode substrate to which an adhesive function is assigned by appropriate transfer pressure may be used.

Further, according to an embodiment of the present invention, when a pattern film for transferring the display pixel is used, since only light emitting diode chips at a specific interval among light emitting device chips formed on a wafer are selectively contacted, it is possible to prevent contamination of the wafer.

[Mode for Invention]

Hereinafter, an embodiment of the present invention will be described through examples. However, scopes of the embodiments are not intended to be limited by the following examples.

**<Examples>**

**<Examples 1 and 2 and Comparative Examples 1 to 6>**

Polydimethylsiloxane (PDMS, product for a mold by the Dow company) was coated at a level of approximately 400 $\mu$m with a gap applicator using a master mold having a projection pattern formed in an intaglio pattern on a stone quartz plate having a flatness of 10 $\mu$m or less and cured at room temperature for 24 hours. The master mold is manufactured by using the photolithography process and by using an etching or photoreactive resin of silicon or glass.

The cured PDMS was covered with silicon-based PSA by a coating or laminating method and a polycarbonate substrate was laminated in such a state and gradually duplicated/released from one side, thereby manufacturing the pattern film for transferring the display pixel.

Whether there are the primary projection pattern and the auxiliary projection pattern and the height of the projection pattern are illustrated in Table 1 below, and the upper area of the primary projection is 100 $\mu$m $\times$ 200 $\mu$m and the upper area of the auxiliary projection is 50 $\mu$m $\times$ 50 $\mu$m (Examples 1 and 2). In respect to the height of the projection pattern, an intaglio depth of the master mold was adjusted by an etching degree or a patterning height. Further, the pitch of the primary projection pattern was 800 $\mu$m and the area ratio occupied by the projection pattern, which is calculated by Equation 1 above was 3.5%. Further, the upper areas of the respective auxiliary projections constituting the auxiliary projection pattern were 12.5% of the upper areas of the respective primary projections constituting the primary projection pattern. In addition, the forms of the primary projection pattern and the auxiliary projection pattern are illustrated in FIG. 2 below.

**<Experimental Example>**

Critical loads, projection area ratios, etc. of the films of Examples 1 and 2 and Comparative Examples 1 to 6 were evaluated and illustrated in Table 1 below.

In respect to the critical loads, a maximum pressure value was measured when a transferred substrate contacts a bottom surface of the polydimethylsiloxane-based film comprising the projection pattern by the transfer pressure. The larger the critical load is, the smaller the deformation of the projection pattern is, and the unnecessary contact with the electrode substrate may be reduced. Accordingly, the releasability with the electrode substrate may be improved after the transfer process.

The criteria for evaluating the conformity of the following transfer process are as follows.

◎: very excellent and within one minute of a tack time

△: excellent and the tack time is more than 1 minute and equal to or less than 5 minutes

X: nonconformity/improvement needed, tack time exceeds 5 minutes

[Table 1]

| | | Projection pattern | Projection height (h, $\mu$m) | Critical load N (kgf) | Total projection area ratio (%) | Auxiliary projection area ratio (auxiliary projection/primary projection, %) | Transfer process conformity |
|---|---|---|---|---|---|---|---|
| | Example 1 | Primary projection + auxiliary projection | 20 | 52.0 (5.3) | 3,5 | 12.5 | ◎ |
| | Example 2 | Primary projection + auxiliary projection | 50 | 88.3 (9.0) | 3.5 | 12.5 | ◎ |
| | Comparative Example 1 | Primary projection | 9 | 10.8 (1.1) | 3.1 | 0 | × |
| | Comparative Example 2 | Primary projection | 20 | 22.6 (2.3) | 3.1 | 0 | × |

(continued)

| | Projection pattern | Projection height (h, $\mu$m) | Critical load N (kgf) | Total projection area ratio (%) | Auxiliary projection area ratio (auxiliary projection/primary projection, %) | Transfer process conformity |
|---|---|---|---|---|---|---|
| Comparative Example 3 | Primary projection | 50 | 44.1 (4.5)) | 3.1 | 0 | △ |
| Comparative Example 4 | Primary projection + auxiliary projection | 9 | 25.5 (2.6) | 3.5 | 12.5 (50×50)/ (100×200) | X |
| Comparative Example 5 | Primary projection + auxiliary projection | 20 | 65.7 (6.7) | 4.7 | 50 (100×100)/ (100×200) | X |
| Comparative Example 6 | Primary projection + auxiliary projection | 20 | 46.1 (4.7) | 3.2 | 3 (25×25)/(100×200) | X |

When the transfer pressure is adjusted to 49.1 N (5 kgf) or less based on a transfer area (100 mm × 100 mm) as described in Example 1 above, it is verified that a bottom portion does not contact except for the projection of the pattern transfer film by a pressure dispersion effect and appropriate projection heights in the primary projection and the auxiliary projection. In this case, a detachment process is easier after the transfer and when a total transfer process tack time is within 1 minute, it may be said that transfer process conformity is excellent.

Further, when the transfer pressure may be further increased as described in Example 2, there is an advantage in that a transfer yield and an attachment characteristic of the electrode substrate may be additionally secured.

Like the result, according to an embodiment of the present invention, since a projection pattern is formed on the surface of the polydimethylsiloxane-based film, a contact surface between the electrode surface and the polydimethylsiloxane-based film can be reduced during the transfer of the display pixel and the polydimethylsiloxane-based film has excellent mold release properties after the transfer of the display pixel.

Further, according to an embodiment of the present invention, when a pattern film for transferring the display pixel is used, since only light emitting device chips at a specific interval among light emitting device chips formed on a wafer are selectively contacted, it is possible to prevent contamination of the wafer.

In addition, according to an embodiment of the present invention, the projection pattern additionally comprises an auxiliary projection pattern in addition to a main projection pattern to prevent the primary projection pattern for transfer pressure from being deformed, and as a result, it is possible to reduce unnecessary contact with an electrode substrate.

## Claims

1. A pattern film for transferring a display pixel, comprising:

   a substrate (10); and
   a polydimethylsiloxane-based film (40) provided on the substrate (10) and comprising a projection pattern on the surface,
   wherein a form of a projection constituting the projection pattern is a polygonal pillar or cylindrical pillar form and an upper surface of the projection is a flat form which means a 10-point surface roughness $R_z$ of 0.5 $\mu$m or less,
   a height of the projection pattern is in the range of 20 $\mu$m to 50 $\mu$m,
   an area ratio occupied by the projection pattern is in the range of 1% to 5% based on an upper plane of the polydimethylsiloxane-based film (40), and
   the projection pattern comprises a primary projection pattern (20) and an auxiliary projection pattern (30), and upper areas of respective auxiliary projections constituting the auxiliary projection pattern (30) are 5% to 20% of the upper areas of respective primary projections constituting the primary projection pattern (20).

2. The pattern film for transferring a display pixel of claim 1, wherein the area ratio occupied by the projection pattern is in the range of 1% to 3.5% based on the upper plane of the polydimethylsiloxane-based film (40).

3. The pattern film for transferring a display pixel of claim 1, wherein adhesion of the surface of the projection pattern, which is a maximum load value applied when a glass substrate having an area of 1 cm $\times$ 1 cm is in contact with the surface of the projection pattern with a load of 9.81 N (1,000 gf) for 30 seconds and then released, is 58.84 kPa (600 gf/cm$^2$) or less.

4. The pattern film for transferring a display pixel of claim 1, wherein each of the pitch of the primary projection pattern (20) and the pitch of the auxiliary projection pattern (30) is independently in the range of 700 $\mu$m to 900 $\mu$m.

5. The pattern film for transferring a display pixel of claim 1, wherein a thickness of the polydimethylsiloxane-based film (40) is in the range of 200 $\mu$m to 800 $\mu$m.

6. The pattern film for transferring a display pixel of claim 1, wherein the display pixel is a light emitting diode (LED) chip.

7. The pattern film for transferring a display pixel of claim 1, further comprising:
an adhesive layer (50) between the substrate (10) and the polydimethylsiloxane-based film (40).

8. A manufacturing method of a display comprising:

preparing a pattern film for transferring a display pixel of any one of claims 1 to 7;
providing a display pixel on the surface of a primary projection pattern (20); and
transferring the display pixel to an electrode substrate for a display.

9. The manufacturing method of a display of claim 8, wherein the display is a transparent light emitting diode display.


**Patentansprüche**

1. Gemusterter Film zum Übertragen eines Anzeigepixels, umfassend ein Substrat (10); und

einen Film (40) auf Basis von Polydimethylsiloxan, der auf dem Substrat (10) bereitgestellt ist und ein Vorsprungsmuster auf der Oberfläche umfasst,
wobei eine Form eines Vorsprungs, der das Vorsprungsmuster ausbildet, eine polygonale Säulen- oder zylindrische Säulenform ist und eine obere Oberfläche des Vorsprungs eine flache Form ist, was eine 10-Punkt-Oberflächenrauigkeit $R_z$ von 0,5 $\mu$m oder weniger bedeutet,
eine Höhe des Vorsprungsmusters in dem Bereich von 20 $\mu$m bis 50 $\mu$m ist, ein Flächenverhältnis, das durch das Vorsprungsmuster besetzt ist, in dem Bereich von 1% bis 5% ist, basierend auf einer oberen Ebene des Films (40) auf Basis von Polydimethylsiloxan,
das Vorsprungsmuster ein Primärvorsprungsmuster (20) und ein Hilfsvorsprungsmuster (30) umfasst, und obere Flächen entsprechender Hilfsvorsprünge, die das Hilfsvorsprungsmuster (30) ausbilden, 5% bis 20% der oberen Flächen entsprechender Primärvorsprünge, die das Primärvorsprungsmuster (20) ausbilden, sind.

2. Gemusterter Film zum Übertragen eines Anzeigepixels nach Anspruch 1, wobei das Flächenverhältnis, das durch das Vorsprungsmuster besetzt ist, in dem Bereich von 1% bis 3,5% ist, basierend auf der oberen Ebene des Films (40) auf Basis von Polydimethylsiloxan.

3. Gemusterter Film zum Übertragen eines Anzeigepixels nach Anspruch 1, wobei eine Anhaftung der Oberfläche des Vorsprungsmusters 58,84 kPa (600 gf/cm$^2$) oder weniger ist, welches ein maximaler Belastungswert ist, der beaufschlagt wird, wenn ein Glassubstrat mit einer Fläche von 1 cm $\times$ 1 cm in Kontakt mit der Oberfläche des Vorsprungsmusters mit einer Belastung von 9,81 N (1000 gf) für 30 Sekunden ist und dann gelöst wird.

4. Gemusterter Film zum Übertragen eines Anzeigepixels nach Anspruch 1, wobei jeder des Zwischenraums des Primärvorsprungsmusters (20) und des Zwischenraumes des Hilfsvorsprungsmusters (30) unabhängig im Bereich von 700 $\mu$m bis 900 $\mu$m ist.

5. Gemusterter Film zum Übertragen eines Anzeigepixels nach Anspruch 1, wobei eine Dicke des Films (40) auf Basis von Polydimethylsiloxan im Bereich von 200 μm bis 800 μm ist.

**6.** Gemusterter Film zum Übertragen eines Anzeigepixels nach Anspruch 1, wobei das Anzeigepixel ein Chip einer lichtemittierenden Diode (LED) ist.

**7.** Gemusterter Film zum Übertragen eines Anzeigepixels nach Anspruch 1, weiter umfassend:
eine Haftstoffschicht (50) zwischen dem Substrat (10) und dem Film (40) auf Basis von Polydimethylsiloxan.

**8.** Herstellungsverfahren einer Anzeige, umfassend:

Herstellen eines gemusterten Films zum Übertragen eines Anzeigepixels nach einem der Ansprüche 1 bis 7,
Bereitstellen eines Anzeigepixels auf der Oberfläche eines Primärvorsprungsmusters (20);
Übertragen des Anzeigepixels auf ein Elektrodensubstrat für eine Anzeige.

**9.** Herstellungsverfahren einer Anzeige nach Anspruch 8 wobei die Anzeige eine transparente Anzeige einer lichtemittierenden Diode ist.

**Revendications**

**1.** Film à motif pour le transfert d'un pixel d'affichage, comprenant :

un substrat (10) ; et
un film à base de polydiméthylsiloxane (40) qui est disposé sur le substrat (10) et comprenant un motif de projection sur la surface de celui-ci,
dans lequel une forme de projection constituant le motif de projection est une forme de pilier polygonal ou de pilier cylindrique et une surface supérieure de la projection est une forme plate qui signifie une rugosité de surface de 10 points $R_z$ of 0,5 μm ou inférieure,
une hauteur du motif de projection se situe dans la plage de 20 μm à 50 μm,
un rapport de surface occupé par le motif de projection se situe dans la plage de 1 % à 5 % sur la base du plan supérieur du film à base de polydiméthylesiloxane (40), et
le motif de projection comprend un motif de projection primaire (20) et un motif de projection auxiliaire (30), et
les zones supérieures des projections auxiliaires respectives constituant le motif de projection auxiliaire (30) sont de 5 % à 20 % des zones supérieures des projections primaires respectives constituant le motif de projection primaire (20).

**2.** Film à motif pour le transfert d'un pixel d'affichage selon la revendication 1, dans lequel le rapport de surface occupé par le motif de projection se situe dans la plage de 1% à 3,5% par rapport au plan supérieur du film à base de polydiméthylsiloxane (40).

**3.** Film à motif pour le transfert d'un pixel d'affichage selon la revendication 1, dans lequel l'adhérence de la surface du motif de projection, qui est une valeur de charge maximale appliquée lorsqu'un substrat en verre ayant une surface de 1 cm × 1 cm est en contact avec la surface du motif de projection avec une charge de 9,81 N (1 000 gf) pendant 30 secondes, puis relâchée, est de 58,84 kPa (600 gf/cm$^2$) ou inférieure.

**4.** Film à motif pour le transfert d'un pixel d'affichage selon la revendication 1, dans lequel chacun du pas du motif de projection primaire (20) et du pas du motif de projection auxiliaire (30) se situe indépendamment dans la plage de 700 μm à 900 μm.

**5.** Film à motif pour le transfert d'un pixel d'affichage selon la revendication 1, dans lequel une épaisseur du film à base de polydiméthylsiloxane (40) se situe dans la plage de 200 μm à 800 μm.

**6.** Film à motif pour le transfert d'un pixel d'affichage selon la revendication 1, dans lequel le pixel d'affichage est une puce à diodes électroluminescentes (DEL).

**7.** Film à motif pour le transfert d'un pixel d'affichage selon la revendication 1, comprenant en outre :
une couche adhésive (50) disposée entre le substrat (10) et le film à base de polydiméthylsiloxane (40).

**8.** Procédé de fabrication d'un affichage comprenant les étapes consistant à :
préparer un film à motif pour le transfert d'un pixel d'affichage selon l'une quelconque des revendications 1 à 7 :

fournir un pixel d'affichage sur la surface d'un motif de projection primaire (20) ; et
transférer le pixel d'affichage sur un substrat d'électrode pour un affichage.

**9.** Procédé de fabrication d'un affichage selon la revendication 8, dans lequel l'affichage est un affichage à diodes électroluminescentes transparent.

[Figure 1]

[Figure 2]

**EP 3 689 593 B1**

**Patent documents cited in the description**

- KR 101754528 B1